# DEMANDE DE BREVET EUROPEEN

(11) **EP 2 835 824 A2**
(43) Date de publication de la demande: **11.02.2015**
(21) Numéro de dépôt: 14180064.9
(22) Date de dépôt: 06.08.2014
(51) Int. Cl.: H01L 23/552, H01L 25/065, H01L 25/00, H01L 27/06

(54) **Interconnexion de plusieurs niveaux d'un empilement de supports de composants electroniques**

(30) Priorité: 09.08.2013 FR 1357933
(71) Demandeur: Commissariat à l'Énergie Atomique et aux Énergies Alternatives, 75015 Paris (FR)
(72) Inventeur: Bouvier, Christophe, 38000 Grenoble (FR); Pares, Gabriel, 38190 Bernin (FR)
(74) Mandataire: Brevalex

(57) **Abrégé**

Procédé de réalisation d'un dispositif microélectronique formé d'un empilement de supports (W) dotés chacun d'un ou plusieurs composants électroniques (C) et comprenant une structure conductrice (170, 470) formée d'un premier via conducteur borgne (171b, 472) et un deuxième via conducteur borgne (171a, 473) de hauteur plus importante, le premier via et le deuxième via étant connectés entre eux.

## Description

### DOMAINE TECHNIQUE

L'invention se rapporte au domaine des dispositifs microélectroniques de type dit « 3D » formés de différents niveaux superposés de supports microélectroniques tels que des plaques, des cartes, des substrats, des ensembles de puces, et concerne plus précisément un procédé de réalisation d'une structure de connexion entre différents niveaux d'une superposition de supports microélectroniques.

Elle prévoit la fabrication d'une structure de connexion pour un dispositif microélectronique 3D, formée de vias conducteurs borgnes ayant un agencement amélioré, et s'applique notamment à des dispositifs comportant une encapsulation (désignée également par l'anglicisme « packaging »).

### ART ANTERIEUR

Afin d'augmenter la densité d'intégration de composants dans un dispositif microélectronique, il est connu de réaliser des dispositifs formés d'un assemblage de plusieurs supports (substrats, plaques, cartes) superposés dotés chacun d'un ou plusieurs composants électroniques tels que des circuits intégrés ou des puces.

L'interconnexion des composants d'un tel dispositif peut être effectuée en trois dimensions par exemple en utilisant les faces latérales de l'empilement de supports.

Afin de réduire l'encombrement des connexions, il est également connu de réaliser des structures communément appelées « vias » traversant un empilement de supports microélectroniques.

Le document « Challenges for 3D IC integration: bonding quality and thermal management », de Leduc et al., IEEE 2007, présente une structure de connexion permettant de connecter entre eux des composants appartenant à des niveaux différents d'une superposition de supports microélectroniques.

Il se pose le problème de trouver un procédé amélioré de réalisation d'une telle structure.

### EXPOSÉ DE L'INVENTION

La présente invention concerne tout d'abord un procédé de réalisation d'un dispositif microélectronique comprenant des étapes de :
a) réalisation, à partir d'un assemblage de supports empilés, dotés chacun d'un ou plusieurs composants électroniques, d'une pluralité de trous borgnes à travers une face dite « face avant » de l'empilement, dont au moins un premier trou borgne traversant un premier support de l'empilement, et au moins un deuxième trou borgne de hauteur plus élevée que celle dudit premier trou borgne et traversant ledit premier support et un deuxième support,
b) dépôt de matériau conducteur dans ledit premier trou borgne, ledit deuxième trou borgne et sur une région donnée de ladite face avant dudit empilement.

Avantageusement, entre l'étape a) et l'étape b), on forme un masquage sur ladite face de l'empilement comprenant une ouverture dévoilant ledit premier trou borgne ledit deuxième trou borgne, et la région donnée situé entre le premier trou borgne et le deuxième trou borgne.

On forme ainsi une structure conductrice comportant un premier élément conducteur tapissant le fond du premier trou borgne et connectée, par l'intermédiaire d'une portion conductrice disposée sur ladite région donnée, à un deuxième élément conducteur tapissant le fond du deuxième trou borgne.

Grâce à la formation du masquage comportant une ouverture, la formation de la structure conductrice est réalisée sans nécessairement avoir à effectuer ultérieurement une gravure de ce matériau.

Le dépôt de matériau conducteur à l'étape b) dans une telle ouverture est réalisé de manière simultanée dans le premier trou borgne, le deuxième trou borgne et la région donnée.

On peut ainsi limiter le nombre d'étapes de réalisation de cette structure d'interconnexion.

Lesdits composants électroniques peuvent être des puces ou des circuits intégrés.

Le premier élément conducteur et le deuxième élément conducteur peuvent former respectivement un premier via conducteur borgne traversant partiellement l'empilement, et un deuxième via conducteur borgne traversant partiellement l'empilement et de hauteur plus importante que celle du premier via conducteur.

On peut réaliser ainsi une connexion deux à deux de composants situés à différents niveaux d'une superposition de supports, ou situés sur des supports différents.

La portion conductrice reliant le premier élément conducteur et le deuxième élément conducteur peut être une zone de connexion de type RDL (RDL pour « redistribution layer »).

L'assemblage peut comprendre au moins trois supports, ledit premier support et ledit deuxième support étant alors empilés sur un troisième support.

Lesdits supports de l'empilement peuvent être recouverts d'au moins une couche d'encapsulation.

Ainsi, le procédé suivant l'invention s'adapte en particulier à des empilements de supports ayant au préalable été soumis à une étape communément appelée de « packaging » ou d'encapsulation.

La couche d'encapsulation des supports peut être à base de matériau composite formé d'un matériau polymère chargé en particules minérales.

Dans ce cas, les trous borgnes sont réalisés par gravure de ce matériau composite.

Avantageusement, les trous borgnes peuvent être formés par perçage à l'aide d'un laser. Un tel procédé permet d'obtenir une bonne sélectivité de gravure, de former des trous ayant un profil précis et s'adapte tout particulièrement à la réalisation de trous dans un empilement hétérogène, comprenant notamment un matériau composite.

L'étape a) de réalisation des trous borgnes peut être réalisée par gravure des supports avec arrêt de gravure respectivement sur ladite première zone conductrice et sur ladite deuxième zone conductrice.

Avantageusement, le premier trou borgne dévoile une première zone conductrice située dans ledit empilement tandis que le deuxième trou borgne dévoile une deuxième zone conductrice située dans ledit empilement.

La première zone conductrice peut être connectée à au moins un composant électronique tel qu'une puce ou un circuit intégré.

La deuxième zone conductrice peut être également connectée à au moins un autre composant électronique, par exemple une autre puce ou un autre circuit intégré.

Lesdites première et deuxième zones conductrices peuvent avantageusement servir de zone d'arrêt de gravure lors de la réalisation des trous borgnes.

Selon une possibilité de mise en oeuvre du procédé, l'étape a) peut comprendre la formation d'un trou borgne traversant une face dite « face avant » d'au moins un support donné parmi lesdits supports, ledit support donné ayant un fond dévoilant une zone conductrice disposée sur une face dite « face arrière » dudit support donné, opposée à ladite face avant dudit support donné.

Selon une possibilité de mise en oeuvre, à l'étape a), des trous borgnes ayant une forme évasée peuvent être formés. Cela facilite ensuite le remplissage des trous à l'étape b).

Selon une possibilité de mise en oeuvre, à l'étape a), le deuxième trou borgne peut être réalisé avec une section transversale supérieure à la section transversale du premier trou borgne.

Les supports peuvent être assemblés préalablement à l'étape a) par l'intermédiaire d'une ou plusieurs couches de collage.

Selon une possibilité de mise en oeuvre particulière du procédé, à l'étape a), au moins un des trous borgnes peut être sous forme d'une tranchée réalisant un contour fermé.

Cela permet par la suite lorsqu'on remplit cette tranchée à l'étape b), de former une enceinte conductrice fermée.

Selon un autre aspect, on prévoit un dispositif microélectronique formé d'un empilement de supports dotés chacun d'un ou plusieurs composants électroniques et comprenant une structure conductrice formée d'au moins un premier élément conducteur s'étendant entre une face donnée dudit empilement et une première zone conductrice située à une première hauteur dans ledit empilement et d'au moins un deuxième élément conducteur s'étendant entre ladite face donnée dudit empilement et une deuxième zone conductrice située à une deuxième hauteur dans ledit empilement, lesdits premier et deuxième éléments conducteurs étant reliés entre eux par l'intermédiaire d'une portion conductrice disposée entre eux sur une région donnée de ladite face donnée dudit empilement.

Avantageusement, le dispositif peut comprendre un autre élément conducteur s'étendant dans ledit empilement entre ladite face donnée dudit empilement et une zone conductrice disposée dans ledit empilement en regard d'un composant électronique donné, ledit autre élément conducteur étant agencé de manière à former une enceinte continue autour dudit composant donné.

Cette enceinte conductrice peut permettre de former pour le composant donné une protection contre des ondes RF ou une zone de dissipation thermique.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1a, 1b, 1c illustrent différents exemples de supports susceptibles d'être intégrés à un dispositif microélectronique réalisé selon un mode de réalisation de l'invention,
- la figure 2 illustre un exemple d'assemblage de supports susceptibles de servir d'élément de départ à un procédé suivant mode de réalisation de l'invention,
- les figures 3, 4, 5 illustrent une réalisation de trous borgnes de différentes profondeurs dans différents exemples d'empilement de supports, en vue de la réalisation de vias conducteurs de hauteurs différentes dans ces empilements,
- la figure 6 illustre une réalisation de trous borgnes de forme évasée, en vue de la réalisation de vias conducteurs ayant une base et un sommet élargi par rapport à cette base,
- la figure 7 illustre une réalisation de trous borgnes de diamètres différents et adaptés en fonction des profondeurs respectives des trous, en vue de la réalisation de vias conducteurs de tailles différentes,
- les figures 8A-8E illustrent un procédé de réalisation d'une structure conductrice dans un assemblage de supports superposés, ladite structure conductrice comprenant des vias conducteurs de hauteurs différentes connectés entre eux et agencés de manière à connecter des éléments de l'assemblage situés à des niveaux différents de l'assemblage,
- les figures 9A-9B illustrent un exemple de réalisation d'un dispositif à supports superposés doté d'une structure conductrice formée de vias conducteurs de hauteurs différentes connectés entre eux ainsi que d'un élément conducteur traversant l'épaisseur d'un support et formant une enceinte conductrice autour d'une puce de ce support,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

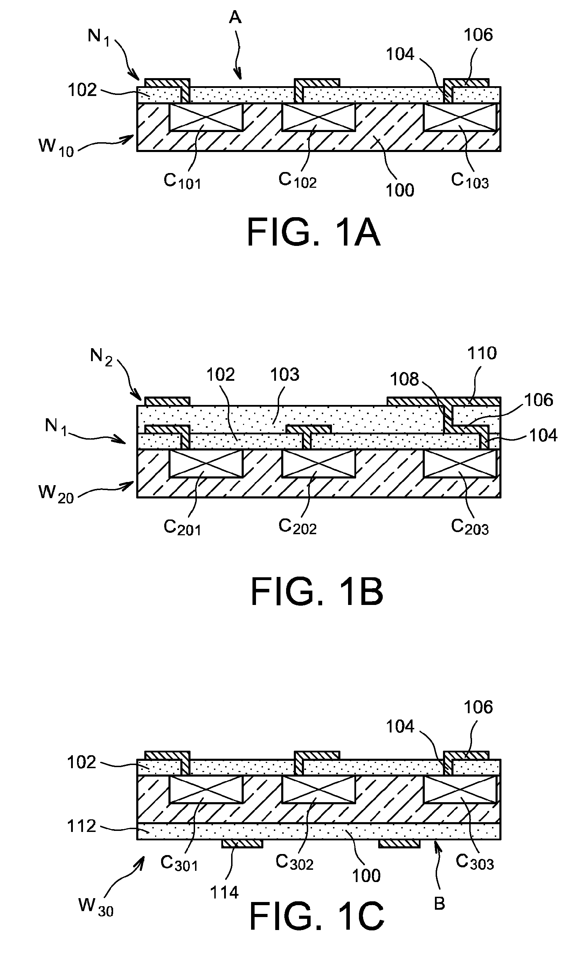

On se réfère tout d'abord aux figures 1A à 1C illustrant différents types de supports microélectroniques, tels que par exemple des plaques («wafer» selon la terminologie anglo-saxonne) W₁₀, W₂₀, W₃₀ susceptibles d'être assemblé(e)s au sein d'un dispositif micro-électronique mis en oeuvre suivant l'invention.

Ces plaques peuvent être formées chacune d'un substrat 100, qui peut être semi-conducteur, par exemple à base de silicium ou de GaAs, ou en variante être en polymère et avoir été reconstitué par exemple par moulage d'une matrice époxy ou par laminage de polymère.

Les plaques W₁₀, W₂₀, W₃₀ sont dotées chacune d'une ou plusieurs puces C₁₀₁, C₁₀₂, C₁₀₃, ou C₂₀₁, C₂₀₂, C₂₀₃, ou C₃₀₁, C₃₀₂, C₃₀₃ et ont une épaisseur (dimension selon l'axe z sur la figure 1A) comprise par exemple entre 10 et 1000 µm par exemple de l'ordre de 100 µm.

Les plaques W₁₀, W₂₀, W₃₀ sont recouvertes sur une de leurs faces, appelée « face avant » A, d'une couche 102 d'encapsulation, à base d'un matériau donné différent de celui du substrat 100, le matériau donné étant de préférence isolant tel qu'un matériau céramique, ou un matériau de type SOG (SOG pour « spin on glass ») ou un matériau composite, qui peut être organique et formé d'au moins un polymère chargé en particules minérales. Par exemple, le matériau composite est un matériau époxy ou du silicone chargé en particules diélectriques telles que de l'oxyde de silicium ou d'aluminium.

Le matériau donné peut être éventuellement photosensible.

La couche d'encapsulation 102 joue ainsi le rôle de couche de passivation et peut avoir une épaisseur comprise par exemple entre 1 µm et 50 µm.

Les puces C₁₀₁, C₁₀₂, C₁₀₃ peuvent être chacune connectées à au moins une zone de connexion conductrice de type RDL (RDL pour « redistribution layer » selon la terminologie anglo-saxonne) formée par exemple d'au moins une zone conductrice 104 traversant la couche d'encapsulation 102 et connectée à une autre zone conductrice 106 s'étendant sur la couche d'encapsulation 102 parallèlement au plan principal du substrat 100 (défini ici comme un plan passant par le substrat et parallèle au plan [O,x,y] sur la figure 1A).

Une plaque peut, comme celle référencée W₂₀ sur la figure 1B, comporter plusieurs couches d'encapsulation 102, 103 superposées, dans lesquelles respectivement, un premier niveau N₁ de connexion(s) de type RDL, et un deuxième niveau N₂ de connexion(s) de type RDL sont disposés. Le deuxième niveau N₂ de connexion peut être alors connecté au premier niveau N₁ et formé par exemple d'au moins une zone conductrice 108 traversant une autre couche 103 d'encapsulation du type de la couche 102 et connectée à un autre zone conductrice 110 s'étendant parallèlement au substrat 100 sur cette autre couche d'encapsulation 103.

Une plaque peut, comme dans l'exemple de la figure 1C, comporter une couche d'encapsulation 112 sur sa face dite « arrière » B, opposée à la face avant. Cette couche 112 peut être de même nature que les couches 102 et 103. Dans cet exemple, la face arrière est également dotée d'éléments conducteurs 114 qui ne sont pas connectés à une puce, et peuvent être prévus par exemple pour réaliser une connexion à un ou plusieurs composants passifs tels qu'une ou plusieurs inductances, et/ou une ou plusieurs capacités et/ou une ou plusieurs résistances.

Pour former un dispositif microélectronique 3D, on peut réaliser tout d'abord un assemblage de plaques du type par exemple de celles qui viennent d'être décrites, que l'on superpose ou que l'on empile.

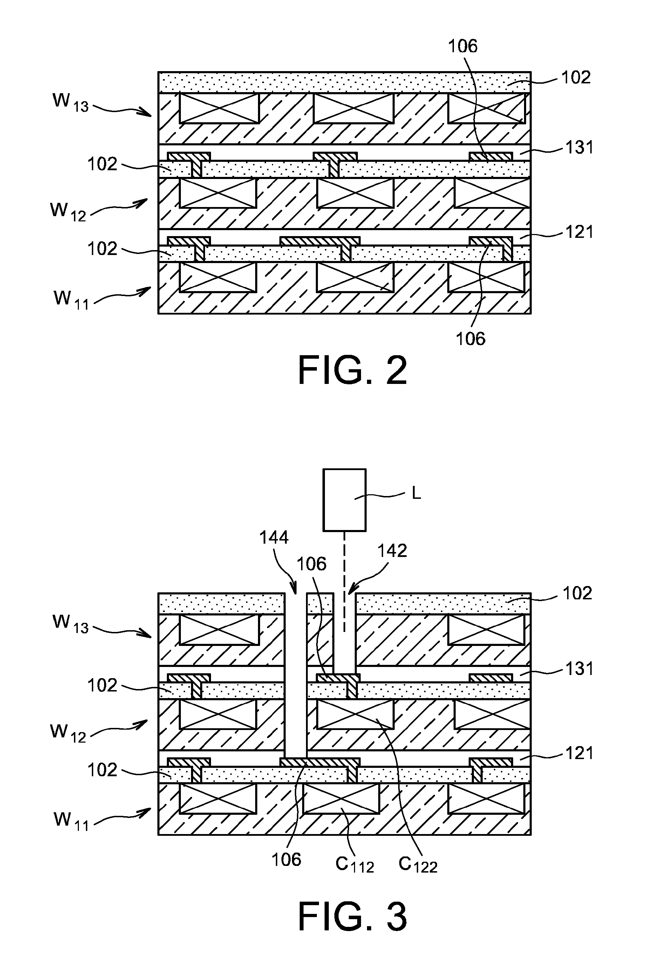

Un exemple d'assemblage de plaques comportant des plaques W₁₁, W₁₂ d'un premier type, par exemple celui illustré sur la figure 1A, ainsi qu'au moins une plaque W₁₃ d'un autre type, est donné sur la figure 2.

Cet assemblage est ici réalisé par collage, des plaques W₁₁, W₁₂ et W₁₂, entre elles, celles-ci étant solidarisées deux à deux par l'intermédiaire de couches de scellement 121, 131 également appelées couches de collage.

Les couches de scellement 121, 131 ont des propriétés adhésives et peuvent être à base d'un matériau différent de celui des couches d'encapsulation 102. Le matériau adhésif utilisé peut être polymère, par exemple tel que du BCB (Benzocyclobutène), ou un polymère époxyde, éventuellement photosensible tel que par exemple le SU8.

Les couches de scellement 121, 131 peuvent être réalisées de manière à encapsuler les éléments conducteurs 106 d'un niveau de connexion(s) RDL et jouer ainsi le rôle d'une couche de passivation et/ou former une couche de passivation supplémentaire.

On forme ensuite des trous borgnes (figures 3, 4, 5, 6, 7) par exemple sous forme de tranchées ou d'ouvertures dans l'empilement de plaques assemblées.

On réalise ainsi, à travers la face avant d'une première plaque donnée située à une extrémité de l'empilement, en particulier au sommet de l'empilement, au moins un premier trou borgne traversant l'épaisseur de la première plaque ainsi qu'au moins un deuxième trou borgne traversant l'épaisseur de la première plaque et d'au moins une deuxième plaque, accolée contre la première plaque, et sur laquelle repose la première plaque.

Par trous « borgnes » on entend que ces trous ne traversent pas toute l'épaisseur de l'empilement. Au contraire de trous totalement traversant, les trous borgnes possèdent un fond situé dans l'épaisseur de l'empilement et dévoilant une région de ce dernier.

Dans un premier exemple de réalisation illustré sur la figure 3, des trous borgnes 142, 144, traversant respectivement la plaque W₁₃ et l'empilement de plaques W₁₃ et W₁₂, sont réalisés.

Le premier trou 142 borgne traverse une couche d'encapsulation 102 formée sur la face supérieure du substrat 100 de la première plaque W₁₃, traverse ce substrat 100, ainsi que la couche de scellement 131 entre la première plaque W₁₃ et la deuxième plaque W₁₂, jusqu'à atteindre la couche d'encapsulation 102 recouvrant la deuxième plaque W₁₂. Le fond du premier trou 142 borgne dévoile une zone de conductrice 106, en particulier de connexion de type RDL connectée à une puce C₁₂₂ de la deuxième plaque W₁₂.

Le deuxième trou 144 borgne traverse la couche d'encapsulation 102 de la première plaque W₁₃, le substrat 100 de la première plaque W₁₃, la couche de scellement 131 entre la première plaque W₁₃ et la deuxième plaque W₁₂, la couche d'encapsulation 102 de la deuxième plaque W₁₂, le substrat 100 de la deuxième plaque W₁₂, la couche de scellement 121 entre la deuxième plaque W₁₂ et la troisième plaque W₁₁ jusqu'à atteindre la couche d'encapsulation 102 recouvrant la troisième plaque W₁₁. Le fond du deuxième trou 144 borgne dévoile une zone conductrice 106 en particulier de connexion de type RDL connectée à une puce C₁₁₂ de la troisième plaque W₁₁.

Pour former les trous 142, 144 un laser L peut être avantageusement utilisé afin d'obtenir une bonne précision au niveau de leur profil et de l'arrêt de gravure.

Un laser dans le domaine de l'infrarouge peut être utilisé pour permettre d'obtenir une bonne sélectivité de gravure. En variante, une mise en oeuvre à l'aide d'un laser émettant dans le domaine de l'UV peut permettre d'obtenir un profil de trou plus précis.

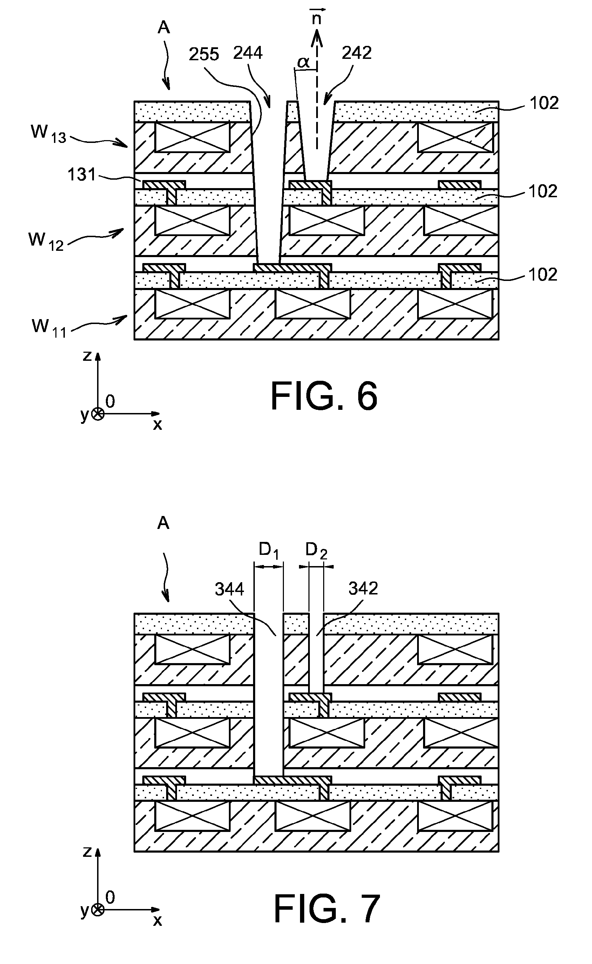

L'utilisation d'un laser permet également de réaliser différents profils de trous, et éventuellement de mettre en oeuvre des trous dont les parois sont inclinées, comme dans l'exemple de réalisation de la figure 6, pour lequel des trous 242, 244 à profil évasé ont été formés et comportent des parois 255 réalisant un angle α par exemple compris entre 75° et 85°, par rapport à une normale *̅n̅*̅ au plan principal des plaques (i.e. un plan passant par une plaque W₁₁ ou W₁₂ ou W₁₃ et parallèle au plan [O,x,y] sur la figure 6).

Le perçage des trous 142, 144 ou 242, 244 est ainsi effectué en regard de régions comportant des zones conductrices, par exemple métalliques, pouvant servir de couches d'arrêt à la gravure laser. L'emploi d'un laser infrarouge permet alors d'obtenir une bonne sélectivité de gravure, en particulier lorsque les zones conductrices sont à base d'un métal tel que le cuivre.

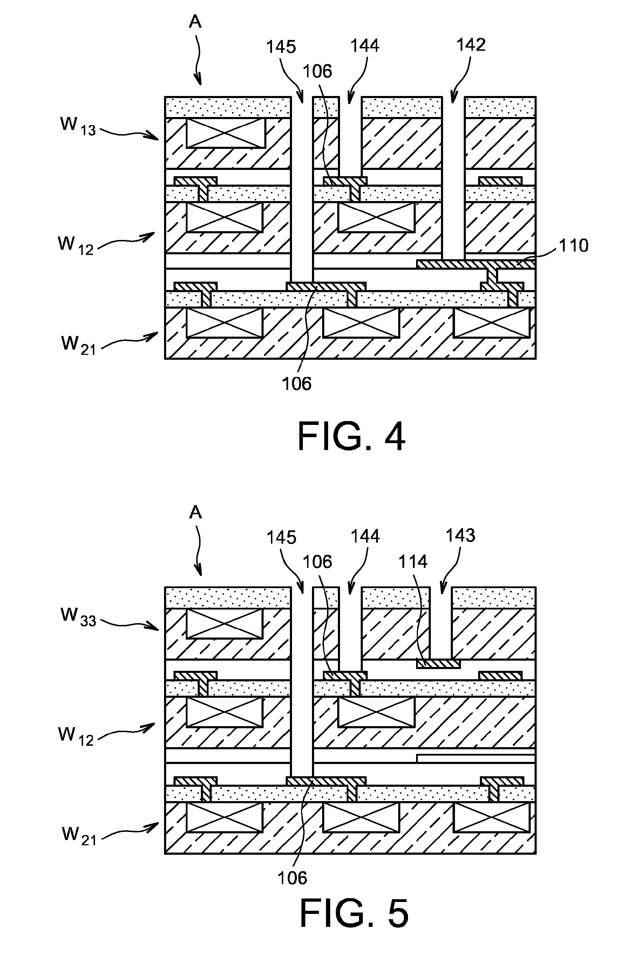

Dans l'exemple de la figure 4, on réalise des trous 142, 144, 145 à travers un assemblage comportant une première plaque W₁₂ et une deuxième plaque, W₁₃ du type de celle de la figure 1A, ainsi qu'une troisième plaque W₂₁ du type de celle de la figure 1B.

Un premier trou borgne 142 traverse la première plaque W₁₃, et comporte au fond une zone de connexion de type RDL connectée à un composant ou un ensemble de composants d'une deuxième plaque W₁₂.

Un deuxième trou borgne 144 traverse quant à lui la première plaque W₁₃, la deuxième plaque W₁₂ et est doté d'un fond dans lequel une zone conductrice 110 d'un deuxième niveau de connexion de type RDL est dévoilée, cette zone conductrice 110 étant connectée à un composant ou un ensemble de composants de la troisième plaque W₂₂.

Un troisième trou borgne 145 traverse la première plaque W₁₃, la deuxième plaque W₁₂ et comporte au fond une zone conductrice 106 d'un premier niveau de connexion de type RDL, cette zone conductrice étant connectée à un composant ou un ensemble de composants de la troisième plaque W₂₂.

Un autre exemple d'empilement est donné sur la figure 5. L'empilement dans lequel sont réalisés des trous borgnes 143, 144, 145, comporte cette fois une première plaque W₃₃ du type de celle illustrée sur la figure 1C reposant sur une deuxième plaque W₁₂ du type de celle illustrée sur la figure 1A, elle-même reposant sur une troisième plaque W₂₁ du type de celle illustrée sur la figure 1B. Un premier trou borgne 143 est réalisé à travers la première plaque W₃₃ et en regard d'une zone conductrice 114 disposée en face arrière de la première plaque W₃₃, un deuxième trou borgne 144 de profondeur supérieure à celle du premier trou borgne 143 est réalisé à travers la première plaque W₃₃ et en regard d'une zone conductrice 106 disposée sur la face avant de la plaque W₁₂. Un troisième trou borgne 145 de profondeur supérieure à celle des trous 143, 144, est réalisé à travers la première plaque W₃₃ et la deuxième plaque W₁₂ en regard d'une zone conductrice 106 disposée en face avant de la troisième plaque W₂₁.

Les trous borgnes 142, 143, 144, 145 réalisés peuvent avoir un diamètre de l'ordre de plusieurs dizaines de micromètres, par exemple de l'ordre de 90 µm.

Dans le mode de réalisation illustré sur la figure 7, des trous 342, 344 sont prévus avec des sections transversales D1, D2 de dimensions différentes (définies des sections mesurées dans un plan parallèle au plan [O,x,y] sur la figure 7) en fonction du niveau dans lequel leurs fonds respectifs se trouvent dans l'empilement de plaques.

Un trou 342 borgne de profondeur donnée dans l'assemblage peut être prévu par exemple avec une section transversale D₁, tandis qu'un autre trou 344 borgne de profondeur supérieure est prévu avec une section transversale D₂ tel que D₂ > D₁.

On peut ainsi adapter la résistance de vias conducteurs destinés à être formés dans ces trous en fonction de leur profondeur.

Ainsi on peut utiliser la résistance de connexion, en fonction des dimensions des trous de manière à réaliser une adaptation d'impédance, en particulier dans le domaine RF.

Après avoir réalisé les trous borgnes, on forme ensuite une structure de connexion comportant des vias conducteurs de hauteurs différentes connectés entre eux par l'intermédiaire d'une zone conductrice s'étendant sur la face supérieure de l'empilement de plaques correspondant à la face supérieure de la première plaque, c'est-à-dire de celle située au sommet de l'assemblage.

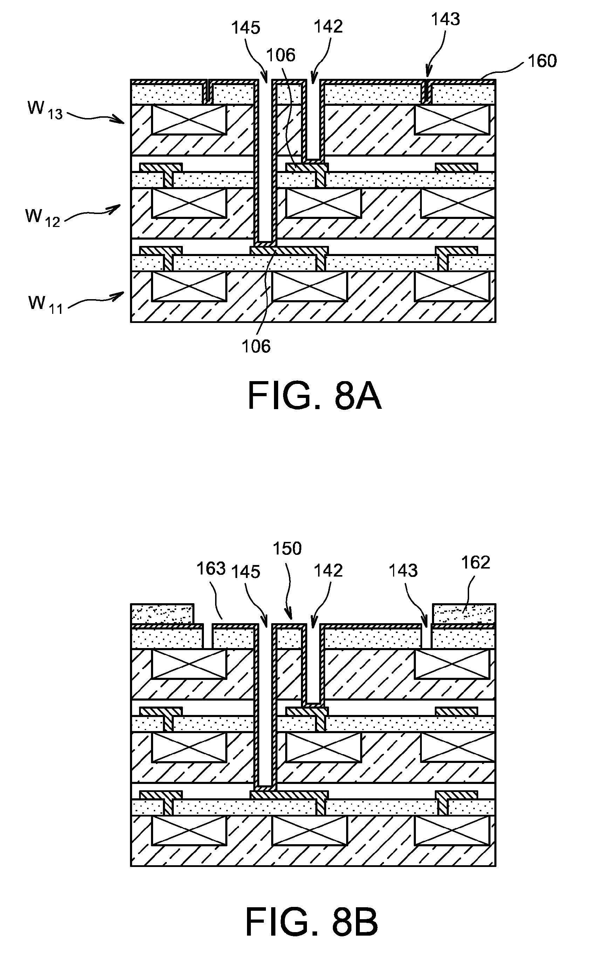

Un exemple de réalisation d'une telle structure de connexion est illustré sur les figures 8A-8E, en prenant par exemple comme matériau de départ l'assemblage de plaques W₂₁, W₁₂, W₁₃, de la figure 4 dans lequel des trous borgnes 142, 144, 145 sont réalisés, par exemple par perçage laser ou à l'aide d'une gravure plasma.

On effectue tout d'abord un dépôt d'une couche 160 servant de couche de germination électrolytique et éventuellement de couche barrière de diffusion dans les trous borgnes 142, 144, 145 et sur la face supérieure de l'assemblage de plaques (figure 8A).

Cette couche 160 peut être par exemple formée à base d'une sous-couche de Ti, par exemple de l'ordre de plusieurs centaines de nanomètres et d'une sous-couche de Cu, par exemple de l'ordre de plusieurs centaines de nanomètres. La couche 160 peut être réalisée par exemple par dépôt de type PVD (pour « physical vapor deposition ») ou iPVD (pour « lonized Physical Vapor Deposition » ou CVD (pour « chemical vapor deposition ») basse température, par exemple inférieure à 200°C.

On réalise ensuite un masquage 162 sur la face avant de l'empilement de plaques W₁₃, W₁₂, W₂₁ par exemple par photolithographie d'une couche de résine photosensible, le masquage comprenant au moins une ouverture 163 dévoilant une région 150 de la face avant de la première plaque W₁₃, ainsi que les trous borgnes 142, 144, 145 (figure 8B).

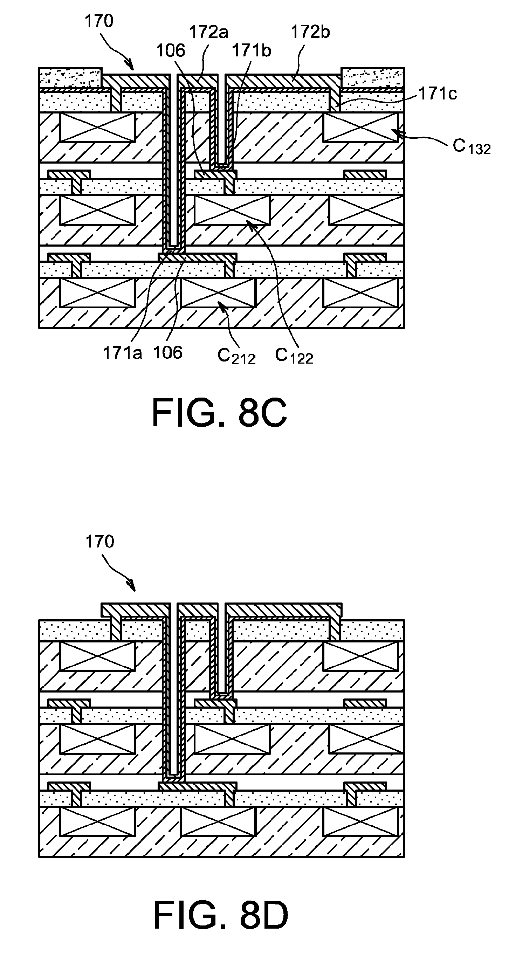

Puis, on forme, par exemple par dépôt métallique par électrolyse, une structure conductrice 170 tapissant les flancs et le fond des trous borgnes 142, 143, 145, ainsi que des zones de la face supérieure de la plaque W₁₃ au sommet de l'empilement. Dans l'ouverture 163, la région 150 et les trous borgnes 142, 144, 145 sont remplis simultanément par du matériau métallique (figure 8C).

La structure conductrice 170 peut être à base de cuivre et avoir une épaisseur par exemple de l'ordre de plusieurs microns, typiquement comprise entre 1 µm et 20 µm.

La structure conductrice 170 réalisée comprend une première zone conductrice 171a recouvrant le fond d'un trou borgne 145, connectée à une deuxième zone conductrice 172a recouvrant une région de la face supérieure de l'empilement, elle-même connectée à une troisième zone conductrice 171b atteignant le fond d'un autre trou borgne 142, cette troisième zone conductrice 171b étant elle-même reliée à une quatrième zone conductrice 172b disposée entre cet autre trou borgne 142 et un trou borgne 143 au fond duquel une cinquième zone conductrice 171c connectée à la quatrième zone conductrice 172b est formée (figure 8C).

Les zones conductrices 171a, 171b, sont formées sur et en contact de zones de connexion 106 de type RDL elles-mêmes connectées respectivement à une puce C₂₁₂ du support W₂₁ situé à la base de l'empilement, à une puce C₁₂₂ du support W₂₁ situé à un autre niveau dans l'empilement, et à une puce C₁₃₂ du support W₁₃ situé à un niveau de l'empilement différent du niveau auquel se trouvent les puces C₂₁₂, et C₁₂₂.

En variante, on peut réaliser les zones conductrices 171a, 172a, 171b, 172b, 171c, par dépôt d'encre métallique selon un procédé de type à jet d'encre (« inkjet selon la terminologie anglo-saxonne), contenant des nano-particules métalliques par exemple d'argent ou de cuivre.

Selon une autre variante, un procédé mixte utilisant le dépôt ECD et le dépôt d'encre métallique, avant ou après la réalisation de la couche 160, peut être effectué afin d'améliorer la conformité de la couche sur laquelle on réalise le dépôt ECD.

Le masquage 162 est ensuite retiré.

Puis, la couche 160 servant de couche de germination catalytique peut être retirée de la face supérieure de l'empilement par gravure (figure 8D).

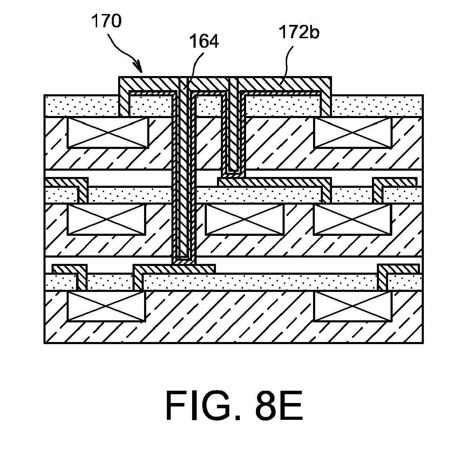

On peut ensuite compléter la réalisation des vias par dépôt d'un matériau métallique 164 venant achever le remplissage des trous borgnes. La structure réalisée est ainsi formée de vias métallisés borgnes connectés entre eux par l'intermédiaire d'une ou plusieurs portions conductrices recouvrant la plaque W₁₃ disposée au sommet de la superposition de plaques W₂₁, W₁₂, W₁₃ (figure 8E).

Le matériau métallique 164 peut être également formé à l'aide d'un dépôt de type à jet d'encre.

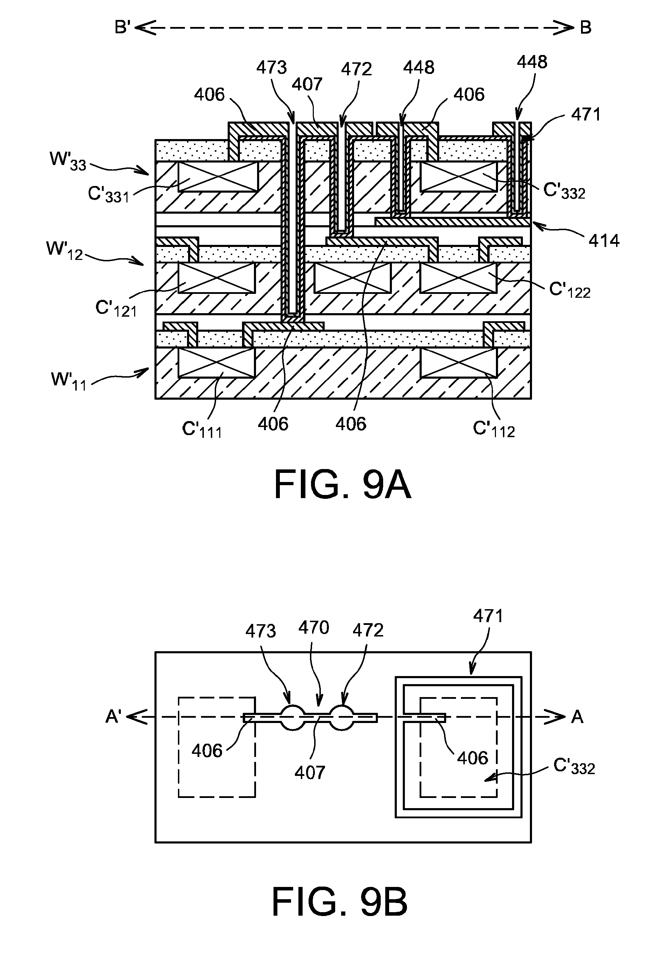

Sur les figures 9A-9B, un autre exemple de réalisation d'un dispositif microélectronique formé de supports superposés est illustré (respectivement selon une vue en coupe transversale parallèle à un axe B'B et selon une vue de dessus).

Ce dispositif comprend un assemblage de supports W'₁₁, W'₁₂, W'₃₃ superposés dotés respectivement de puces C'₁₁₁ et C'₁₁₂, C'₁₂₁ et C'₁₂₂, C'₃₃₁ et C'₃₃₂.

Dans un support W'₃₃, un trou borgne sous forme d'une tranchée 448 traverse le support W'₃₃ et entoure une puce C'₃₃₂ de manière à atteindre une zone conductrice 414 disposée en face arrière du support W'₃₃, en regard de la puce C'₃₃₂. Le trou borgne 448 sous forme de tranchée réalise un contour fermé.

Une zone conductrice 471 par exemple à base d'un métal recouvrant le fond et les parois verticales de ce trou borgne 448, est ainsi agencé de manière à former une paroi conductrice ou un mur conducteur ou une enceinte conductrice fermée autour de la puce C'₃₃₂. Cette zone conductrice 471 peut fonctionner comme une zone de blindage ou une cage de Faraday en particulier lorsque le dispositif comprend des composants RF. Cette zone conductrice 471 peut également remplir la fonction de zone de dissipation thermique.

Dans cet exemple, la zone conductrice 471 est connectée à la zone conductrice 414 disposée en face arrière du support W'₃₃ ainsi qu'à une zone de connexion 406 de type RDL elle-même connectée à la puce C'₃₃₂. La zone conductrice 471 peut être éventuellement reliée électriquement à la masse de la puce C'₃₃₂.

Le dispositif comporte également un via conducteur 472 traversant partiellement l'assemblage et connecté à un autre via conducteur 473 traversant le support W'₃₃ et de hauteur plus faible que celle du via 472. Le via conducteur 472 réalise une connexion entre des puces C'₃₃₁ et C'₁₁₁ situés à différents étages de l'empilement de supports W'₁₁, W'₁₂, W'₃₃. Pour cela le via 472 peut être connecté à des zones conductrices 206 de type RDL elles-mêmes connectées aux puces C'₃₃₁ et C'₁₁₁.

Le via conducteur 473 réalise quant à lui une connexion avec une puce C'₁₂₂ située à un étage de la superposition de supports W'₁₁, W'₁₂, W'₃₃ de ceux où se trouvent les puces C'₃₃₁ et C'₁₁₁.

Une connexion entre les vias 472 et 473 est réalisée par l'intermédiaire d'une zone conductrice 407 agencée sur le support W'₃₃.

Ainsi, la puce C'₁₁₁ située à un premier niveau de l'empilement de supports, la puce C'₁₂₂ située à un deuxième niveau de l'empilement de supports, et la puce C'₃₃₁ située à un troisième niveau de l'empilement de supports sont interconnectées.

Les exemples de réalisation qui ont été donnés en liaison avec les figures 1 à 9 prévoient des assemblages de 3 supports empilés, mais un procédé suivant l'invention peut s'appliquer à la mise en oeuvre d'assemblage de plus de 3 supports.

## Revendications

1. Procédé de réalisation d'un dispositif microélectronique comprenant des étapes de :
a) réalisation, à partir d'un assemblage de supports (W) empilés, dotés chacun d'un ou plusieurs composants électroniques (C), d'une pluralité de trous borgnes (142, 143, 144, 145, 242, 244, 342, 344, 448) à travers une face (A) dite « face avant » de l'empilement, dont au moins un premier trou borgne (142, 242, 342) traversant un premier support (W₁₃,W₃₃), et au moins un deuxième trou borgne (144, 145, 244, 344) traversant ledit premier support et un deuxième support (W₁₂), puis,
- formation d'un masquage (162) sur ladite face avant de l'empilement, le masquage comprenant au moins une ouverture (163) dévoilant le premier trou borgne (142), le deuxième trou borgne (145) et une région donnée (150) de la face avant de l'empilement située entre le premier et le deuxième trou borgne, puis,
b) dépôt de matériau conducteur simultanément dans le premier trou borgne, le deuxième trou borgne ainsi que sur la région donnée (150), de manière à former une structure conductrice comportant un élément conducteur (171b) tapissant le fond du premier trou borgne et reliant un deuxième élément conducteur (171a) tapissant le fond du deuxième trou borgne, lesdits premier et deuxième éléments conducteurs étant reliés entre eux par l'intermédiaire d'une portion conductrice (172a) disposée sur ladite région donnée.

2. Procédé selon la revendication 1, dans lequel l'assemblage comprend au moins trois supports assemblés, le premier et le deuxième support étant empilés sur un troisième support.

3. Procédé selon l'une des revendications 1 ou 2, dans lequel le premier trou borgne (142) dévoile une première zone conductrice (106) et dans lequel le deuxième trou borgne (145) dévoile une deuxième zone conductrice (106), ladite première zone conductrice et/ou ladite deuxième zone conductrice étant connectée(s) à au moins un composant électronique (C₁₂₂, C₂₁₂).

4. Procédé de réalisation selon la revendication 3 dans lequel l'étape a) de réalisation des trous borgnes est réalisée par gravure des supports avec arrêt de gravure respectivement sur ladite première zone conductrice et sur ladite deuxième zone conductrice.

5. Procédé selon la revendication 4, dans lequel lesdits supports sont à base d'au moins un matériau composite, les trous borgnes étant réalisés par gravure de ce matériau composite.

6. Procédé selon l'une des revendications 1 à 5, dans lequel l'étape a) comprend la formation d'un trou borgne (143) traversant une face dite « face avant » (A) d'au moins un support donné (W₃₃) parmi lesdits supports, ledit support donné ayant un fond dévoilant une zone conductrice (114) disposée sur une face dite « face arrière » dudit support donné (W₃₃), opposée à ladite face avant dudit support donné.

7. Procédé selon l'une des revendications 1 à 6, dans lequel lesdits trous borgnes sont formés par gravure de type perçage à l'aide d'un laser (L).

8. Procédé selon l'une des revendications 1 à 7, dans lequel l'étape a) est réalisée de sorte que lesdits trous borgnes (242, 244) ont une forme évasée.

9. Procédé selon l'une des revendications 1 à 8, dans lequel l'étape a) est réalisée de sorte que le deuxième trou borgne (344) a une section transversale supérieure à la section transversale du premier trou borgne (342).

10. Procédé selon l'une des revendications 1 à 9, dans lequel lesdits supports sont formés d'un substrat (100) recouvert d'au moins une couche d'encapsulation (102, 103) à base de matériau polymère.

11. Procédé selon l'une des revendications 1 à 10, lesdits supports étant assemblés par l'intermédiaire d'une ou plusieurs couches de collage (131, 121).

12. Procédé selon l'un des revendications 1 à 11, dans lequel à l'étape a), au moins un trou borgne est sous forme d'une tranchée réalisant un contour fermé.
